# EUROPÄISCHE PATENTSCHRIFT

(11) **EP 2 171 121 B1**
(45) Veröffentlichungstag und Bekanntmachung des Hinweises auf die Patenterteilung: **01.10.2014**
(21) Anmeldenummer: 08759678.9
(22) Anmeldetag: 16.05.2008
(51) Int. Cl.: C23C 30/00, C23C 4/12, C23C 14/08, C23C 14/22, C23C 28/04

(54) **WERZEUG MIT MEHRLAGIGER METALLOXIDBESCHICHTUNG UND VERFAHREN ZUM HERSTELLEN DES BESCHICHTETEN WERKZEUGS**
TOOL WITH MULTILAYERED METAL OXIDE COATING AND METHOD OF MANUFACTURING THE COATED TOOL
OUTIL RECOUVERT D'UN REVÊTEMENT D'OXYDE MÉTALLIQUE MULTICOUCHE ET SON PROCÉDÉ DE FABRICATION

(30) Priorität: 02.07.2007 DE 102007030735
(43) Veröffentlichungstag der Anmeldung: 07.04.2010
(73) Patentinhaber: WALTER AG, 72072 Tübingen (DE)
(72) Erfinder: SCHIER, Veit, 70771 Echterdingen (DE)
(74) Vertreter: WSL Patentanwälte Partnerschaft mbB
(86) Internationale Anmeldenummer: PCT/EP2008/056037
(87) Internationale Veröffentlichungsnummer: WO 2009/003755

(56) Entgegenhaltungen:
- EP-A- 2 037 000
- DE-A1-102004 044 240
- JP-A- 2005 262 355
- JP-A- 2006 192 543
- US-A1- 2005 170 162
- KOHARA T ET AL: "Deposition of [alpha]-Al2O3 hard coatings by reactive magnetron sputtering" SURFACE & COATINGS TECHNOLOGY ELSEVIER SWITZERLAND, Bd. 185, Nr. 2-3, 22. Juli 2004 (2004-07-22), Seiten 166-171, XP002538574 ISSN: 0257-8972

## Beschreibung

Die Erfindung betrifft ein Schneidwerkzeug mit einem Grundkörper und einer darauf aufgebrachten mehrlagigen Beschichtung, wobei wenigstens zwei übereinander angeordnete Lagen der mehrlagigen Beschichtung Metalloxid des gleichen Metalls oder von verschiedenen Metal-len enthalten oder daraus bestehen.

### Stand der Technik

Schneidwerkzeuge bestehen aus einem Grundkörper, der beispielsweise aus Hartmetall, Cermet, Stahl oder Schnellarbeitsstahl hergestellt ist. Zu Erhöhung der Standzeiten oder auch zu Verbesserung der Schneideigenschaften wird auf den Grundkörper häufig eine ein- oder mehrlagige Beschichtung aufgebracht. Diese ein- oder mehrlagige Beschichtung umfasst beispielweise metallische Hartstoffschichten, Oxidschichten und dergleichen. Zum Aufbringen der Beschichtung werden CVD-Verfahren (chemische Gasphasenabscheidung; chemical vapour deposition) und/oder PVD-Verfahren (physikalische Gasphasenabscheidung; physical vapour deposition) angewendet. Mehre Lagen innerhalb einer Beschichtung können ausschließlich mittels CVD-Verfahren, ausschließlich mittels PVD-Verfahren oder durch einer Kombination dieser Verfahren aufgebracht werden.

Bei den PVD-Verfahren unterscheidet man zwischen verschiedenen Verfahrensvarianten, wie i) Magnetronsputtern, ii) Lichtbogenverdampfen (Arc-PVD), iii) Ionenplattierung, iv) Elektronenstrahlverdampfung und v) Laserablation. Magnetronsputtern und Lichtbogenverdampfen zählen zu den am häufigsten für die Beschichtung von Werkzeugen angewendeten PVD-Verfahren. Innerhalb einzelner PVD-Verfahrensvarianten gibt es wiederum unterschiedliche Modifikationen, wie beispielweise ungepulstes oder gepulstes Magnetronsputtern oder ungepulstes oder gepulstes Lichtbogenverdampfen usw.

Das Target im PVD-Verfahren kann aus einem reinen Metall oder einer Kombination von zwei oder mehr Metallen bestehen. Umfaßt das Target mehrere Metalle, so werden alle diese Metalle gleichzeitig in die bei dem PVD-Verfahren aufgebaute Lage einer Beschichtung eingebaut. Das Mengenverhältnis der Metalle zueinander in der aufgebauten Lage wird von dem Mengenverhältnis der Metalle in dem Target abhängen, aber auch von den Bedingungen in dem PVD-Verfahren, da einzelne Metalle unter bestimmten Bedingungen in höheren Mengen aus dem Target herausgelöst werden und/oder sich in höheren Mengen auf dem Substrat abscheiden als andere Metalle.

Zur Erzeugung bestimmter Metallverbindungen werden dem Reaktionsraum des PVD-Verfahrens reaktive Gase zugeführt, wie z.B. Stickstoff zur Erzeugung von Nitriden, Sauerstoff zur Erzeugung von Oxiden, kohlenstoffhaltige Verbindungen zur Erzeugung von Carbiden, Carbonitriden, Oxicarbiden etc. oder Gemische dieser Gase zur Erzeugung von entsprechenden Mischverbindungen.

Die EP-A-0668369 offenbart ein PVD-Beschichtungsverfahren, bei dem Hartstoffschichten, bestehend aus Nitriden oder Karbonitriden der Metalle Ti, Zr, Hf oder aus Legierungen von TiAl, ZrAl, HfAl, TiZr, TiZrAl, mit einem unbalanzierten Magnetron hergestellt werden, wobei während einer bestimmten Zeitspanne des Beschichtungsprozesses zusätzliches Beschichtungsmaterial aus einer kathodischen Bogenentladungsverdampfung auf die zu beschichtenden Substrate abgeschieden wird.

Die DE-A-102004044240 offenbart das Aufbringen einer oder mehrerer Metalloxidschichten auf ein Schneidwerkzeug im PVD-Verfahren, speziell durch Magnetronsputtern.

Die DE-A-19937284 beschreibt einen elektrisch leitenden Mehrschichtaufbau auf einer metallischen Unterlage mit einer ersten Schicht aus einem sich durch natürlich gebildetes Oxid oberflächlich passivierenden Metallmaterial, insbesondere Chrom, und einer mittels eines PVD-Verfahrens aus einem Gold- oder Goldlegierungsmaterial aufgebrachten weiten Schicht. Diese zweite Schicht ist in der Lage, die elektrisch isolierende Wirkung des natürlich gebildeten Oxidfilms der ersten Schicht wenigstens teilweise aufzuheben. Eingesetzt werden derartig beschichtete Anordnungen beispielsweise als Trägerteile zur geschirmten Aufnahme von Elektronikkomponenten.

Die DE-A-19651592 beschreibt ein beschichtetes Schneidwerkzeug mit einer mehrlagigen Beschichtung, die wenigsten eine Aluminiumoxidlage und metallische Hartstofflagen umfasst. Die metallischen Hartstofflagen sind beispielsweise mittels PVD-Verfahren aufgebrachte TiAIN-Lagen. Auch die direkt darauf aufgebrachte Aluminiumoxidschicht ist im PVD-Verfahren abgeschieden.

Die JP 2006-192543 A beschreibt ein beschichtetes Schneidwerkzeug mit einer mehrlagigen Beschichtung mit einer durch reaktives Sputtern abgeschiedenen ersten Lage aus γ-Aluminiumoxid und weiteren durch Lichtbogenverdampfen abgeschiedenen Lagen, wobei die über der γ-Aluminiumoxid-Lage abgeschiedene zweite Lage keine Metalloxidlage ist.

### Aufgabe

Die Aufgabe der vorliegenden Aufgabe bestand darin, gegenüber dem Stand der Technik verbesserte Schneidwerkzeuge bereitzustellen.

Gelöst wird die erfindungsgemäße Aufgabe durch ein Schneidwerkzeug mit einem Grundkörper und einer darauf aufgebrachten mehrlagigen Beschichtung, wobei wenigstens zwei übereinander angeordnete Lagen der mehrlagigen Beschichtung Metalloxid von verschiedenen Metallen der Elemente der Gruppen IVa bis Vlla des Periodensystems und/oder des Aluminiums und/oder des Siliziums enthalten oder daraus bestehen, dadurch gekennzeichnet, daß die wenigstens zwei übereinander angeordneten Metalloxidlagen unmittelbar ohne Zwischenlage(n) übereinander angeordnet sind und nacheinander durch verschiedene PVD-Verfahren hergestellt sind, ausgewählt unter i) rMS, ii) Lichtbogenverdampfen (Arc-PVD), iii) Ionenplattierung, iv) Elektronenstrahlverdampfung und v) Laserablation, wobei Modifikationen der jeweiligen Verfahren i) bis v) keine verschiedenen PVD-Verfahren sind.

Im Sinne der vorliegenden Erfindung sind i) Magnetronsputtern, ii) Lichtbogenverdampfen (Arc-PVD), iii) Ionenplattierung, iv) Elektronenstrahlverdampfung und v) Laserablation "verschiedene PVD-Verfahren". Innerhalb jedes der PVD-Verfahren i) bis v) gibt es Modifikationen, wobei im Sinne der vorliegenden Erfindung die Modifikationen eines PVD-Verfahrens nicht als nicht als "verschiedene PVD-Verfahren" angesehen werden.

Modifikationen des PVD-Verfahrens "Magnetronsputtern" sind beispielsweise "duales Magnetronsputtern", "RF-Magnetronsputtern", "bipolares Magnetronsputtern", "unipolares Magnetronsputtern", "DC-Dioden-Magnetronsputtern", "DC-Trioden-Magnetronsputtern", "gepulstes Magnetronsputtern", "ungepulstes Magnetronsputtern" und Mischformen der vorgenannten Verfahren.

Ähnlich gibt es auch für die PVD-Verfahren "Lichtbogenverdampfen" (Arc-PVD), "lonenplattierung", "Elektronenstrahlverdampfung" und "Laserablation" verschiedene Modifikationen und Mischformen von Modifikationen. Die Modifikationen der PVD-Verfahren i) bis v) sind den Fachleuten auf dem Gebiet bestens bekannt und brauchen daher hierin nicht im einzelnen näher erläutert zu werden.

Das Aufbringen einer mehrlagigen Beschichtung, auch einer mehrere Metalloxidlagen umfassenden Beschichtung, auf ein Schneidwerkzeug als Verschleißschutzbeschichtung ist seit langem bekannt. Neu ist hingegen das Aufbringen der Metalloxidlagen mit verschiedenen PVD-Verfahren auf dem selben Grundkörper, was zu völlig neuen Beschichtungen mit neuen Eigenschaften führt. Diese neuartige Beschichtung der vorliegenden Erfindung eröffnet ein breites Spektrum an Möglichkeiten zur Verbesserung und/oder Anpassung der Verschleißfestigkeit, der Standzeiten und/oder der Schneideigenschaften von Schneidwerkzeugen.

Die Verschleißbeständigkeit, Standfestigkeit und Schneideigenschaften einer Beschichtung auf einem Schneidwerkzeug hängt von verschiedenen Faktoren ab, wie beispielsweise dem Material des Grundkörpers des Schneidwerkzeugs, der Abfolge, Art und Zusammensetzung der in der Beschichtung vorhandenen Lagen, der Dicke der verschiedenen Lagen und nicht zuletzt der Art der mit dem Schneidwerkzeug durchgeführten Schneidoperation. Für ein und dasselbe Schneidwerkzeug können sich unterschiedliche Verschleißfestigkeiten in Abhängigkeit von der Art des zu bearbeitenden Werkstücks, dem jeweiligen Bearbeitungsverfahren und den weiteren Bedingungen während der Bearbeitung, wie beispielweise Entwicklung hoher Temperaturen oder Verwendung korrosiver Kühlflüssigkeiten, ergeben. Darüber hinaus unterscheidet man zwischen verschiedenen Verschleißarten, die je nach Bearbeitungsvorgang die Nutzungsdauer eines Werkzeugs, d. h. seine Standzeit, stärker oder geringer beeinflussen können. Die Weiterentwicklung und Verbesserung von Schneidwerkzeugen ist daher stets im Hinblick darauf zu betrachten, welche Werkzeugeigenschaften verbessert werden sollen, und unter vergleichbaren Bedingungen gegenüber dem Stand der Technik zu beurteilen.

Es hat sich überraschenderweise gezeigt, daß sich durch die Kombination verschiedener PVD-Verfahren zum Aufbringen von wenigstens zwei übereinander angeordneten Metalloxidlagen auf den Grundkörper die Eigenschaften der gesamten Beschichtung gezielt beeinflussen lassen und Schneidwerkzeuge mit verbesserter Verschleißbeständigkeit, verbesserter Schneidleistung und längeren Standzeiten herstellbar sind.

Durch das Aufbringen der Metalloxidlagen mit verschiedenen PVD-Verfahren können beispielsweise Metalloxidlagen mit unterschiedlichen Eigenspannungszuständen (Druck- und Zugeigenspannungen) in relativ hohen Schichtdicken (z.B. größer als 5 bis 10 µm oder mehr) erzeugt werden. Durch die Einstellung geringfügig unterschiedlicher Gitterparameter (z.B. in Al₂O₃ und (AlCr)₂O₃) bei gleicher Gitterstruktur kann z.B. eine starke Verspannung des Gitters und damit eine Härtesteigerung herbeigeführt werden. Weitere Eigenschaften, wie hohe Warmhärte, thermodynamische Stabilität, geringe Rißausbreitung und der Wärmeausdehnungskoeffizient, lassen sich in einer erfindungsgemäßen Beschichtung gezielt beeinflussen.

Gemäß der Erfindung sind in der Beschichtung des Schneidwerkzeugs die zwei übereinander angeordneten Metalloxidlagen unmittelbar ohne Zwischenlage(n) übereinander angeordnet. In Abhängigkeit von den abgeschiedenen Lagen kann sich hierdurch mit Vorteil eine besonders gute Haftung zwischen den Lagen ergeben.

In einer weiteren Ausführungsform der Erfindung ist in der Beschichtung des Schneidwerkzeugs eine der wenigstens zwei übereinander angeordneten Metalloxidlagen durch Magnetronsputtern und eine weitere darüber oder darunter angeordnete der wenigstens zwei übereinander angeordneten Metalloxidlagen durch Lichtbogenverdampfen (Arc-PVD) hergestellt.

In einer weiteren Ausführungsform der Erfindung ist in der Beschichtung des Schneidwerkzeugs sind die wenigstens zwei übereinander angeordneten Metalloxidlagen nacheinander durch verschiedene PVD-Verfahren in der gleichen PVD-Vorrichtung hergestellt, ohne den Schneidwerkzeugkörper zwischen dem Aufbringen der wenigstens zwei übereinander angeordneten Metalloxidlagen aus der PVD-Vorrichtung zu entfernen und/oder ohne das bei dem PVD-Verfahren in der PVD-Vorrichtung herrschende Vakuum zwischen dem Aufbringen der wenigstens zwei übereinander angeordneten Metalloxidlagen abzubauen.

In einer weiteren Ausführungsform der Erfindung ist in der Beschichtung des Schneidwerkzeugs weist wenigstens eine der wenigstens zwei übereinander angeordneten Metalloxidlagen weiterhin wenigstens eine Nebenkomponente aus Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis Vlla des Periodensystems und/oder des Aluminiums und/oder des Siliziums, gemischtmetallischen Phasen sowie Phasengemischen der vorgenannten Verbindungen auf.

In einer weiteren Ausführungsform der Erfindung ist in der Beschichtung des Schneidwerkzeugs umfaßt die Beschichtung weitere Hartstofflagen aus Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, gemischtmetallischen Phasen sowie Phasengemischen der vorgenannten Verbindungen.

In einer weiteren Ausführungsform der Erfindung ist in der Beschichtung des Schneidwerkzeugs weisen die Lagen der Beschichtung Schichtdicken von 10 nm bis 50 µm, vorzugsweise von 20 nm bis 20 µm, besonders bevorzugt von 0,2 µm bis 4 µm auf.

In einer weiteren Ausführungsform der Erfindung ist in der Beschichtung des Schneidwerkzeugs weisen die Beschichtung eine Vickers-Härte (Hv) von 500 bis 4000, vorzugsweise von 700 bis 3500, besonders bevorzugt von 1500 bis 3000 auf.

In einer weiteren Ausführungsform der Erfindung ist in der Beschichtung des Schneidwerkzeugs ist der Grundkörper aus Hartmetall, Cermet, Stahl oder Schnellarbeitsstahl (HSS) hergestellt.

In einer weiteren Ausführungsform der Erfindung ist in der Beschichtung des Schneidwerkzeugs haben die Metalloxide der wenigstens zwei übereinander angeordneten Metalloxidlagen gleiche Kristallstruktur. Hierdurch kann je nach abgeschiedenem Material eine verbesserte Haftung der Lagen untereinander erreicht werden. Beispiele für Metalloxide gleicher Kristallstruktur sind α-Al₂O₃ / Cr₂O₃.

In einer alternativen Ausführungsform der Erfindung ist in der Beschichtung des Schneidwerkzeugs haben die Metalloxide der wenigstens zwei übereinander angeordneten Metalloxidlagen verschiedene Kristallstruktur. Dies kann je nach abgeschiedenem Material besonders vorteilhaft sein, um das Säulenwachstum von Kristallen zu unterbinden und Stängelkristallite zu verhindern, was zu erhöhter Sprödheit führen würde.

In einer weiteren Ausführungsform der Erfindung ist in der Beschichtung des Schneidwerkzeugs haben die im XRD-, XPS- und/oder TEM-Spektrum die höchste Intensität aufweisenden Phasen (Hauptphasen) der wenigstens zwei übereinander angeordneten Metalloxidlagen gleiche Kristallstruktur.

Hauptphasen im Sinne der vorliegenden Erfindung sind solche Phasen in einer Lage der Beschichtung, die gegenüber anderen Phasen der gleichen Lage in deutlichem Überschuß vorhanden sind.

In einer weiteren Ausführungsform der Erfindung ist in der Beschichtung des Schneidwerkzeugs haben die im XRD-, XPS- und/oder TEM-Spektrum die höchste Intensität aufweisenden Phasen (Hauptphasen) der wenigstens zwei unmittelbar übereinander angeordneten Metalloxidlagen verschiedene Kristallstruktur.

Die Erfindung umfaßt auch ein Verfahren zur Herstellung eines Schneidwerkzeugs mit einem Grundkörper und einer darauf aufgebrachten mehrlagigen Beschichtung, bei dem man in wenigstens zwei übereinander angeordneten Lagen der mehrlagigen Beschichtung Metalloxid von verschiedenen Metallen der Elemente der Gruppen IVa bis VIIa des Periodensystems und/oder des Aluminiums und/oder des Siliziums unmittelbar ohne Zwischenlage(n) übereinander durch verschiedene PVD-Verfahren aufbringt, wobei die PVD-Verfahren unter i) rMS, ii) Lichtbogenverdampfen (Arc-PVD), iii) Ionenplattierung, iv) Elektronenstrahlverdampfung und v) Laserablation ausgewählt sind und wobei Modifikationen der jeweiligen Verfahren i) bis v) keine verschiedenen PVD-Verfahren sind.

In einer weiteren Ausführungsform des erfindungsgemäßen Verfahrens bringt man eine der wenigstens zwei übereinander angeordneten Metalloxidlagen durch Magnetronsputtern und eine weitere darüber oder darunter angeordnete der wenigstens zwei übereinander angeordneten Metalloxidlagen durch Lichtbogenverdampfen (Arc-PVD) auf.

In einer weiteren Ausführungsform des erfindungsgemäßen Verfahrens bringt man die wenigstens zwei übereinander angeordneten Metalloxidlagen nacheinander durch verschiedene PVD-Verfahren in der gleichen PVD-Vorrichtung auf, ohne den Schneidwerkzeugkörper zwischen dem Aufbringen der wenigstens zwei übereinander angeordneten Metalloxidlagen aus der PVD-Vorrichtung zu entfernen und/oder ohne das bei dem PVD-Verfahren in der PVD-Vorrichtung herrschende Vakuum zwischen dem Aufbringen der wenigstens zwei übereinander angeordneten Metalloxidlagen abzubauen.

Es versteht sich von selbst, daß sämtliche Einzelmerkmale, wie sie für bestimmte erfindungsgemäße Ausführungsformen hierin beschrieben sind, soweit dies technisch sinnvoll und möglich ist, mit allen übrigen beschriebenen Merkmalen erfindungsgemäßer Ausführungsformen kombinierbar sind und solche Kombinationen als im Rahmen dieser Beschreibung offenbart angesehen werden. Aus die Einzelnennung sämtlicher möglicher Kombinationen wird hierin lediglich aus Gründen der besseren Lesbarkeit verzichtet.

Weitere Vorteile, Merkmale und Ausführungsformen der vorliegenden Erfindung werden anhand der nachfolgenden Beispiele erläutert.

### BEISPIELE

In einer PVD-Beschichtungsanlage (Flexicoat; Hauzer Techno Coating) wurden Hartmetallsub-strate der Zusammensetzung HM-Grobkorn + 10,5 Gew.-% Co (HM-Grobkorn = WC-Hartmetall mit mittlerer Korngröße von 3 - 5 µm) mit einer mehrlagigen PVD-Beschichtung versehen. Die Substratgeometrie war SEHW120408 bzw. ADMT160608-F56 (nach DIN-ISO 1832). Vor der Abscheidung der Lagen wurde die Anlage auf 1x10⁻⁵ mbar evakuiert und die Hartmetalloberflä-che durch Ionenätzen mit 170 V Vorspannung gereinigt.

### Abscheidung der Lagen:

### TiAlN (Lichtbogenverdampfen; LB)

■ Target: Ti/Al (33/67 At.-%) Rundquelle (63 mm Durchmesser),
■ 80 Ampere, 495°C, 3 Pa N₂-Druck, 40 Volt Substratvorspannung,

### γ-Al₂O₃ (Lichtbogenverdampfen; LB)

■ Target: Al-Rundquelle (63 mm Durchmesser),
■ 80 Ampere, 495°C, 0,7 Pa O₂-Druck, 70 Volt Substratvorspannung,

### γ-Al₂O₃ (reaktives Magnetronsputtern; rMS)

■ Target: Al
■ 10 kW Sputterleistung, 495°C, 0,5 Pa Ar-Druck, 150 Volt Substratvorspannung (unipolar gepulst),

### ZrO₂ (Lichtbogenverdampfen; LB)

■ Target: Zr-Rundquelle (63 mm Durchmesser),
■ 80 Ampere, 495°C, 0,7 Pa O₂-Druck, 70 Volt Substratvorspannung,

### ZrO₂ (reaktives Magnetronsputtern; rMS)

■ Target: Zr
■ 10 kW Sputterleistung, 495°C, 0,5 Pa Ar-Druck, 150 Volt Substratvorspannung (unipolar gepulst),

Ausgehend vom Grundkörper wurden folgende Beschichtungen durch verschiedene PVD-Verfahren aufgebracht:

### Beispiel 1 (Erfindung):

| Zusammensetzung | Dicke der Lage | PVD-Verfahren |
|---|---|---|
| TiAlN | 3,0µm | LB |
| γ-Al₂O₃ | 0,2µm | rMS |
| ZrO₂ | 0,2µm | LB |
| γ-Al₂O₃ | 0,2µm | rMS |
| ZrO₂ | 0,2µm | LB |
| γ-Al₂O₃ | 0,2µm | rMS |
| ZrO₂ | 0,2µm | LB |
| γ-Al₂O₃ | 0,2µm | rMS |
| ZrO₂ | 0,2µm | LB |

### Vergleichsbeispiel 1a:

| Zusammensetzung | Dicke der Lage | PVD-Verfahren |
|---|---|---|
| TiAlN | 3,0µm | LB |
| γ-Al₂O₃ | 0,2µm | rMS |
| ZrO₂ | 0,2µm | rMS |
| γ-Al₂O₃ | 0,2µm | rMS |
| ZrO₂ | 0,2µm | rMS |
| γ-Al₂O₃ | 0,2µm | rMS |
| ZrO₂ | 0,2µm | rMS |
| γ-Al₂O₃ | 0,2µm | rMS |
| ZrO₂ | 0,2µm | rMS |

### Vergleichsbeispiel 1b:

| Zusammensetzung | Dicke der Lage | PVD-Verfahren |
|---|---|---|
| TiAlN | 3,0µm | LB |
| γ-Al₂O₃ | 0,25µm | LB |
| ZrO₂ | 0,25µm | LB |
| γ-Al₂O₃ | 0,25µm | LB |
| ZrO₂ | 0,2µm | LB |

In einem Fräsversuch an einem Werkstück aus 42CrMoV4-Stahl (Festigkeit: 850 MPa) wurden die Werkzeuge aus Beispiel 1 und Vergleichsbeispielen 1a und 1b verglichen. Es wurde im Gleichlauf ohne Kühlschmierstoff mit einer Schnittgeschwindigkeit v_{c} = 236 m/min und einem Zahnvorschub f_{z} = 0,2 mm gefräst.

Der Verschleiß wurde auf der Freifläche als mittlere Verschleißmarkenbreite VB in mm (an der Hauptschneide) nach einem Fräsweg von 4800 mm gemessen. Es wurden folgende Verschleißmarkenbreiten VB festgestellt:

| | Verschleißmarkenbreite VB |
|---|---|
| **Beispiel 1:** | 0,08 mm |
| **Vergleichsbeispiel 1a**: | 0,12 mm |
| **Vergleichsbeispiel 1b:** | 0,18 mm |

Die Vergleichsbeispiele 1a und 1b zeigten einen annähernd linearen Verschleißanstieg. Die Ergebnisse zeigen für das erfindungsgemäße Werkzeug gemäß Beispiel 1 ein signifikant besseres Verschleißverhalten als für die Werkzeuge gemäß den Vergleichsbeispielen 1a und 1b.

### Beispiel 2 (Erfindung):

| Zusammensetzung | Dicke der Lage | PVD-Verfahren |
|---|---|---|
| TiAlN | 3,0µm | LB |
| γ-Al₂O₃ | 0,2µm | rMS |
| ZrO₂ | 0,2µm | LB |
| γ-Al₂O₃ | 0,2µm | rMS |
| ZrO₂ | 0,2µm | LB |
| γ-Al₂O₃ | 0,2µm | rMS |

### Vergleichsbeispiel 2:

| Zusammensetzung | Dicke der Lage | PVD-Verfahren |
|---|---|---|
| TiAlN | 3,0µm | LB |
| γ-Al₂O₃ | 1,0µm | rMS |

Die Werkzeuge aus Beispiel 2 und Vergleichsbeispiel 2 wurden in dem gleichen Fräsversuch, wie er für die Werkzeuge von Beispiel 1 und die Vergleichsbeispiele 1 a und 1 b beschieben ist, verglichen. Es wurden folgende Verschleißmarkenbreiten VB festgestellt:

| | Verschleißmarkenbreite VB |
|---|---|
| **Beispiel 2:** | 0,08 mm |
| **Vergleichsbeispiel 2:** | 0,11 mm |

Die Ergebnisse zeigen für das erfindungsgemäße Werkzeug gemäß Beispiel 2 ein signifikant besseres Verschleißverhalten als für das Werkzeug gemäß Vergleichsbeispiel 2.

## Patentansprüche

1. Schneidwerkzeug mit einem Grundkörper und einer darauf aufgebrachten mehrlagigen Beschichtung, wobei wenigstens zwei übereinander angeordnete Lagen der mehrlagigen Beschichtung Metalloxid von verschiedenen Metallen der Elemente der Gruppen IVa bis VIIa des Periodensystems und/oder des Aluminiums und/oder des Siliziums enthalten oder daraus bestehen, **dadurch gekennzeichnet, daß** die wenigstens zwei übereinander angeordneten Metalloxidlagen unmittelbar ohne Zwischenlage(n) übereinander angeordnet sind und nacheinander durch verschiedene PVD-Verfahren hergestellt sind, ausgewählt unter i) rMS, ii) Lichtbogenverdampfen (Arc-PVD), iii) Ionenplattierung, iv) Elektronenstrahlverdampfung und v) Laserablation, wobei Modifikationen der jeweiligen Verfahren i) bis v) keine verschiedenen PVD-Verfahren sind.

2. Schneidwerkzeug nach einem der vorangegangenen Ansprüche, **dadurch gekennzeichnet, daß** eine der wenigstens zwei übereinander angeordneten Metalloxidlagen durch rMS und eine weitere darüber oder darunter angeordnete der wenigstens zwei übereinander angeordneten Metalloxidlagen durch Lichtbogenverdampfen (Arc-PVD) hergestellt ist.

3. Schneidwerkzeug nach einem der vorangegangenen Ansprüche, **dadurch gekennzeichnet, daß** die wenigstens zwei übereinander angeordneten Metalloxidlagen nacheinander durch verschiedene PVD-Verfahren in der gleichen PVD-Vorrichtung hergestellt sind, ohne den Schneidwerkzeugkörper zwischen dem Aufbringen der wenigstens zwei übereinander angeordneten Metalloxidlagen aus der PVD-Vorrichtung zu entfernen und/oder ohne das bei dem PVD-Verfahren in der PVD-Vorrichtung herrschende Vakuum zwischen dem Aufbringen der wenigstens zwei übereinander angeordneten Metalloxidlagen abzubauen.

4. Schneidwerkzeug nach einem der vorangegangenen Ansprüche, **dadurch gekennzeichnet, daß** wenigstens eine der wenigstens zwei übereinander angeordneten Metalloxidlagen Metalloxid von genau einem Metall aufweist.

5. Schneidwerkzeug nach einem der vorangegangenen Ansprüche, **dadurch gekennzeichnet, daß** wenigstens eine der wenigstens zwei übereinander angeordneten Metalloxidlagen weiterhin wenigstens eine Nebenkomponente aus Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, gemischtmetallischen Phasen sowie Phasengemischen der vorgenannten Verbindungen aufweist.

6. Schneidwerkzeug nach einem der vorangegangenen Ansprüche, **dadurch gekennzeichnet, daß** die Beschichtung weitere Hartstofflagen aus Carbiden, Nitriden, Oxiden, Carbonitriden, Oxinitriden, Oxicarbiden, Oxicarbonitriden, Boriden, Boronitriden, Borocarbide, Borocarbonitride, Borooxinitride, Borooxocarbide, Borooxocarbonitride, Oxoboronitriden der Elemente der Gruppen IVa bis VIIa des Periodensystems und/oder des Aluminiums und/oder des Siliziums, gemischtmetallischen Phasen sowie Phasengemischen der vorgenannten Verbindungen umfaßt.

7. Schneidwerkzeug nach einem der vorangegangenen Ansprüche, **dadurch gekennzeichnet, daß** die Lagen der Beschichtung Schichtdicken von 10 nm bis 50 µm, vorzugsweise von 20 nm bis 20 µm, besonders bevorzugt von 0,2 µm bis 4 µm aufweisen.

8. Schneidwerkzeug nach einem der vorangegangenen Ansprüche, **dadurch gekennzeichnet, daß** die Beschichtung eine Vickers-Härte (Hv) von 500 bis 4000, vorzugsweise von 700 bis 3500, besonders bevorzugt von 1500 bis 3000 aufweist.

9. Schneidwerkzeug nach einem der vorangegangenen Ansprüche, **dadurch gekennzeichnet, daß** der Grundkörper aus Hartmetall, Cermet, Stahl oder Schnellarbeitsstahl (HSS) hergestellt ist.

10. Schneidwerkzeug nach einem der vorangegangenen Ansprüche, **dadurch gekennzeichnet, daß** die Metalloxide der wenigstens zwei übereinander angeordneten Metalloxidlagen verschiedene Kristallstruktur haben.

11. Schneidwerkzeug nach einem der vorangegangenen Ansprüche, **dadurch gekennzeichnet, daß** die im XRD-, XPS- und/oder TEM-Spektrum die höchste Intensität aufweisenden Phasen (Hauptphasen) der wenigstens zwei übereinander angeordneten Metalloxidlagen verschiedene Kristallstruktur haben.

12. Verfahren zur Herstellung eines Schneidwerkzeugs mit einem Grundkörper und einer darauf aufgebrachten mehrlagigen Beschichtung, bei dem man in wenigstens zwei übereinander angeordneten Lagen der mehrlagigen Beschichtung Metalloxid von verschiedenen Metallen der Elemente der Gruppen IVa bis Vlla des Periodensystems und/oder des Aluminiums und/oder des Siliziums unmittelbar ohne Zwischenlage(n) übereinander durch verschiedene PVD-Verfahren aufbringt, wobei die PVD-Verfahren unter i) rMS, ii) Lichtbogenverdampfen (Arc-PVD), iii) Ionenplattierung, iv) Elektronenstrahlverdampfung und v) Laserablation ausgewählt sind und wobei Modifikationen der jeweiligen Verfahren i) bis v) keine verschiedenen PVD-Verfahren sind.

13. Verfahren nach Anspruch 12, **dadurch gekennzeichnet, dass** man eine der wenigstens zwei übereinander angeordneten Metalloxidlagen durch rMS und eine weitere darüber oder darunter angeordnete der wenigstens zwei übereinander angeordneten Metalloxidlagen durch Lichtbogenverdampfen (Arc-PVD) aufbringt.

14. Verfahren nach einem der Ansprüche 12 oder 13, **dadurch gekennzeichnet, dass** man, die wenigstens zwei übereinander angeordneten Metalloxidlagen nacheinander durch verschiedene PVD-Verfahren in der gleichen PVD-Vorrichtung aufbringt, ohne den Schneidwerkzeugkörper zwischen dem Aufbringen der wenigstens zwei übereinander angeordneten Metalloxidlagen aus der PVD-Vorrichtung zu entfernen und/oder ohne das bei dem PVD-Verfahren in der PVD-Vorrichtung herrschende Vakuum zwischen dem Aufbringen der wenigstens zwei übereinander angeordneten Metalloxidlagen abzubauen.

## Claims

1. A cutting tool having a base body and a multilayered coating applied thereto, wherein at least two layers, arranged one on top of the other, of the multilayered coating contain, or consist of, metal oxide of different metals of the Groups IVa to VIIa of the periodic system and/or aluminium and/or silicon, **characterised in that** the at least two metal oxide layers arranged one on top of the other are arranged directly on one another without intermediate layer(s) and are produced successively by different PVD processes selected from i) rMS, ii) arc vapour deposition (arc-PVD), iii) ion plating, iv) electron beam vapour deposition and v) laser deposition, wherein modifications of the respective processes i) to v) do not constitute different PVD-processes.

2. A cutting tool according to one of the preceding claims, **characterised in that** one of the at least two metal oxide layers arranged one on top of the other is produced by rMS, and another of the at least two metal oxide layers arranged one on top of the other, which is arranged thereabove or therebelow, is produced by arc vapour deposition (arc-PVD).

3. A cutting tool according to one of the preceding claims, **characterised in that** the at least two metal oxide layers arranged one on top of the other are produced successively by different PVD-processes in the same PVD-apparatus, without the cutting tool body being removed from the PVD-apparatus between application of the at least two metal oxide layers arranged one on top of the other, and/or without the vacuum which prevails in the PVD-apparatus during the PVD process being reduced between application of the at least two metal oxide layers arranged one on top of the other.

4. A cutting tool according to one of the preceding claims, **characterised in that** at least one of the at least two metal oxide layers arranged one on top of the other has metal oxide of just one metal.

5. A cutting tool according to one of the preceding claims, **characterised in that** at least one of the at least two metal oxide layers arranged one on top of the other further has at least one secondary component from carbides, nitrides, oxides, carbonitrides, oxinitrides, oxicarbides, oxicarbonitrides, borides, boronitrides, borocarbides, borocarbonitrides, boroox-initrides, borooxocarbides, borooxocarbonitrides, oxoboronitrides of the elements of Groups IVa to VIIa of the periodic system and/or aluminium and/or silicon, mixed metal phases and phase mixes of the afore-mentioned compounds.

6. A cutting tool according to one of the preceding claims, **characterised in that** the coating comprises further hard material layers consisting of carbides, nitrides, oxides, carbonitrides, oxinitrides, oxicarbides, oxicarbonitrides, borides, boronitrides, borocarbides, borocarbonitrides, borooxinitrides, borooxocarbides, borooxocarbonitrides, oxoboronitrides of the elements from groups IVa to VIIa of the periodic system and/or aluminium and/or silicon, mixed metal phases and phase mixes of the afore-mentioned compounds.

7. A cutting tool according to one of the preceding claims, **characterised in that** the layers of the coating have layer thicknesses of 10 nm to 50 µm, preferably of 20 nm to 20 µm, particularly preferably of 0.2 µm to 4 µm.

8. A cutting tool according to one of the preceding claims, **characterised in that** the coating has a Vickers hardness (Hv) of between 500 and 4000, preferably of between 700 and 3500, particularly preferably of between 1500 and 3000.

9. A cutting tool according to one of the preceding claims, **characterised in that** the base body is produced from hard metal, cermet, steel or high-speed steel (HSS).

10. A cutting tool according to one of the preceding claims, **characterised in that** the metal oxides of the at least two metal oxide layers arranged one on top of the other have different crystal structures.

11. A cutting tool according to one of the preceding claims, **characterised in that** within the XRD, XPS and/or TEM spectrum the phases which have the highest intensity (the main phases) of the at least two metal oxide layers arranged one on top of the other have different crystal structures.

12. A process for the production of a cutting tool with a base body and a multilayered coating applied thereto, wherein in at least two layers of the multilayered coating arranged one on top of the other metal oxide of different metals of the Groups IVa to VIIa of the periodic system and/or aluminium and/or silicon is applied directly on one another without intermediate layer(s) by different PVD processes, wherein the PVD-processes are selected from i) rMS, ii) arc vapour deposition (arc-PVD), iii) ion plating, iv) electron beam vapour deposition and v) laser deposition, and wherein modifications of the respective processes i) to v) do not constitute different PVD-processes.

13. A process according to Claim 12, **characterised in that** one of the at least two metal oxide layers arranged one on top of the other is applied by rMS, and a further one of the at least two metal oxide layers arranged one on top of the other, arranged thereon or thereunder, is applied by arc vapour deposition (arc-PVD).

14. A process according to one of Claims 12 or 13, **characterised in that** the at least two metal oxide layers arranged one on top of the other are applied successively by different PVD-processes in the same PVD-apparatus, without the cutting tool body being removed from the PVD-apparatus between the application of the at least two metal oxide layers arranged one on top of the other, and/or without the vacuum which prevails in the PVD-apparatus during the PVD-process being reduced between application of the at least two metal oxide layers arranged one on top of the other.

## Revendications

1. Outil de coupe comportant un corps de base et un revêtement multicouche appliqué pardessus, au moins deux couches superposées l'une à l'autre du revêtement multicouche contenant, ou en étant constituées, un oxyde métallique de différents métaux des éléments des Groupes IVa à VIIa du Tableau Périodique et/ou d'aluminium et/ou de silicium, **caractérisé en ce que** les au moins deux couches d'oxydes métalliques superposées l'une à l'autre sont disposées directement l'une au-dessus de l'autre sans aucune couche intermédiaire, et sont fabriquées l'une après l'autre par différents procédés PVD choisis parmi i) la technique rMS, ii) le PVD à arc électrique (Arc-PVD), iii) le placage ionique, iv) l'évaporation par faisceau d'électrons et v) l'ablation laser, les modifications de chacun des procédés i) à v) n'étant pas des procédés PVD différents.

2. Outil de coupe selon l'une des revendications précédentes, **caractérisé en ce que** l'une des au moins deux couches d'oxydes métalliques superposées l'une à l'autre est fabriquée par rMS, et une autre des au moins deux couches d'oxydes métalliques superposées l'une à l'autre, disposée au-dessus ou au-dessous, est fabriquée par PVD à arc électrique (Arc-PVD).

3. Outil de coupe selon l'une des revendications précédentes, **caractérisé en ce que** les au moins deux couches d'oxydes métalliques superposées l'une à l'autre sont fabriquées l'une après l'autre par différents procédés PVD dans le même équipement PVD, sans retirer de l'équipement PVD le corps de l'outil de coupe entre l'application des au moins deux couches d'oxydes métalliques superposées l'une à l'autre, et/ou sans dégrader, pendant le procédé PVD, le vide régnant dans l'équipement PVD entre l'application des au moins deux couches d'oxydes métalliques superposées l'une à l'autre.

4. Outil de coupe selon l'une des revendications précédentes, **caractérisé en ce qu'**au moins l'une des au moins deux couches d'oxydes métalliques superposées l'une à l'autre comprend un oxyde métallique exactement un métal.

5. Outil de coupe selon l'une des revendications précédentes, **caractérisé en ce qu'**au moins l'une des au moins deux couches d'oxydes métalliques superposées l'une à l'autre comprend en outre au moins un composant secondaire constitué de carbures, de nitrures, d'oxydes, de carbonitrures, d'oxynitrures, d'oxycarbures, d'oxycarbonitrures, de borures, de boronitrures, de borocarbures, de borocarbonitrures, de borooxynitrures, de borooxycarbures, de boroxocarbonitrures, d'oxoboronitrures des éléments des Groupes IVa à VIIa du Tableau Périodique et/ou d'aluminium et/ou de silicium, des phases métalliques mixtes, ainsi que des mélanges de phases des composés mentionnés.

6. Outil de coupe selon l'une des revendications précédentes, **caractérisé en ce que** le revêtement comprend des couches de matériaux durs supplémentaires constituées de carbures, de nitrures, d'oxydes, de carbonitrures, d'oxynitrures, d'oxycarbures, d'oxycarbonitrures, de borures, de boronitrures, de borocarbures, de borocarbonitrures, de borooxynitrures, de borooxocarbures, de borooxocarbonitrures, d'oxoboronitrures des éléments des Groupes IVa à VIIa du Tableau Périodique et/ou d'aluminium et/ou de silicium, des phases métalliques mixtes, ainsi que des mélanges de phases des composés mentionnés ci-dessus.

7. Outil de coupe selon l'une des revendications précédentes, **caractérisé en ce que** les couches du revêtement présentent des épaisseurs de couches de 10 nm à 50 µm, de préférence de 20 nm à 20 µm, d'une manière particulièrement préférée de 0,2 µm à 4 µm.

8. Outil de coupe selon l'une des revendications précédentes, **caractérisé en ce que** le revêtement présente une dureté Vickers (Hv) de 500 à 4000, de préférence de 700 à 3500, d'une manière particulièrement préférée de 1500 à 3000.

9. Outil de coupe selon l'une des revendications précédentes, **caractérisé en ce que** le corps de base est fabriqué en métal dur, cermet, acier ou acier rapide (HSS).

10. Outil de coupe selon l'une des revendications précédentes, **caractérisé en ce que** les oxydes métalliques des au moins deux couches d'oxydes métalliques superposées l'une à l'autre ont des structures cristallines différentes.

11. Outil de coupe selon l'une des revendications précédentes, **caractérisé en ce que** les phases présentant l'intensité maximale dans le spectre XRD, XPS et/ou MET (phases principales) des au moins deux couches d'oxydes métalliques superposées l'une à l'autre, ont des structures cristallines différentes.

12. Procédé de fabrication d'un outil de coupe comportant un corps de base et un revêtement multicouche disposé pardessus, dans lequel on applique, dans au moins deux couches superposées l'une à l'autre du revêtement multicouche, un oxyde métallique de différents métaux des éléments des Groupes IVa à VIIa du Tableau Périodique et/ou d'aluminium et/ou de silicium, l'une au-dessus de l'autre sans aucune couche intermédiaire par différents procédés PVD, le procédé PVD étant choisi parmi i) la technique rMS, ii) le PVD à arc électrique (Arc-PVD), iii) le placage ionique, iv) l'évaporation par faisceau d'électrons, et v) l'ablation laser, et les modifications des différents procédés i) à v) n'étant pas des procédés PVD différents.

13. Procédé selon la revendication 12, **caractérisé en ce qu'**on applique l'une des au moins deux couches d'oxydes métalliques superposées l'une à l'autre par rMS, et une autre des au moins deux couches d'oxydes métalliques superposées l'une à l'autre disposée au-dessus ou en-dessous, par PVD à arc électrique (Arc-PVD).

14. Procédé selon l'une des revendications 12 ou 13, **caractérisé en ce qu'**on applique les au moins deux couches d'oxydes métalliques superposées l'une à l'autre l'une après l'autre par différents procédés PVD dans le même équipement PVD, sans retirer de l'équipement PVD le corps de l'outil de coupe entre l'application des au moins deux couches d'oxydes métalliques superposées l'une à l'autre, et/ou sans dégrader le vide, régnant dans le procédé PVD dans l'équipement PVD, entre l'application des au moins deux couches d'oxydes métalliques superposées l'une à l'autre.
